# EUROPÄISCHE PATENTSCHRIFT

(11) **EP 1 761 695 B1**
(45) Veröffentlichungstag und Bekanntmachung des Hinweises auf die Patenterteilung: **12.12.2007**
(21) Anmeldenummer: 05749502.0
(22) Anmeldetag: 18.05.2005
(51) Int. Cl.: F02D 41/20, H01L 41/04

(54) **STEUERGERÄT FÜR PIEZO-AKTOREN VON KRAFTSTOFF-EINSPRITZVENTILEN**
CONTROL DEVICE FOR PIEZO ACTUATORS OF FUEL INJECTION VALVES
APPAREIL DE COMMANDE POUR ACTIONNEURS PIEZO-ELECTRIQUES DE SOUPAPES D'INJECTION DE CARBURANT

(30) Priorität: 11.06.2004 DE 102004028516
(43) Veröffentlichungstag der Anmeldung: 14.03.2007
(73) Patentinhaber: Siemens VDO Automotive AG, 93055 Regensburg (DE)
(72) Erfinder: GÖTZENBERGER, Martin, 85051 Ingolstadt (DE)
(86) Internationale Anmeldenummer: PCT/EP2005/052274
(87) Internationale Veröffentlichungsnummer: WO 2005/121534

(56) Entgegenhaltungen:
- EP-A- 0 379 182
- EP-A- 1 418 328
- WO-A-01/33061
- DE-A1- 10 113 801
- DE-A1- 10 251 685
- DE-A1- 19 734 895

## Beschreibung

Die Erfindung betrifft ein Steuergerät für Piezo-Aktoren von Kraftstoff-Einspritzventilen gemäß Anspruch 1, insbesondere von Piezo-Kraftstoff-Einspritzventilen für Brennkraftmaschinen in Kraftfahrzeugen.

Piezo-Aktoren benötigen eine sehr hohe Spannung und Dynamik des sie ansteuernden Steuergeräts. Als generell problematisch für aktuelle hochintegrierte Steuergeräte erweisen sich die auftretende verlustleistung sowie der Platzbedarf und auch die Kosten.

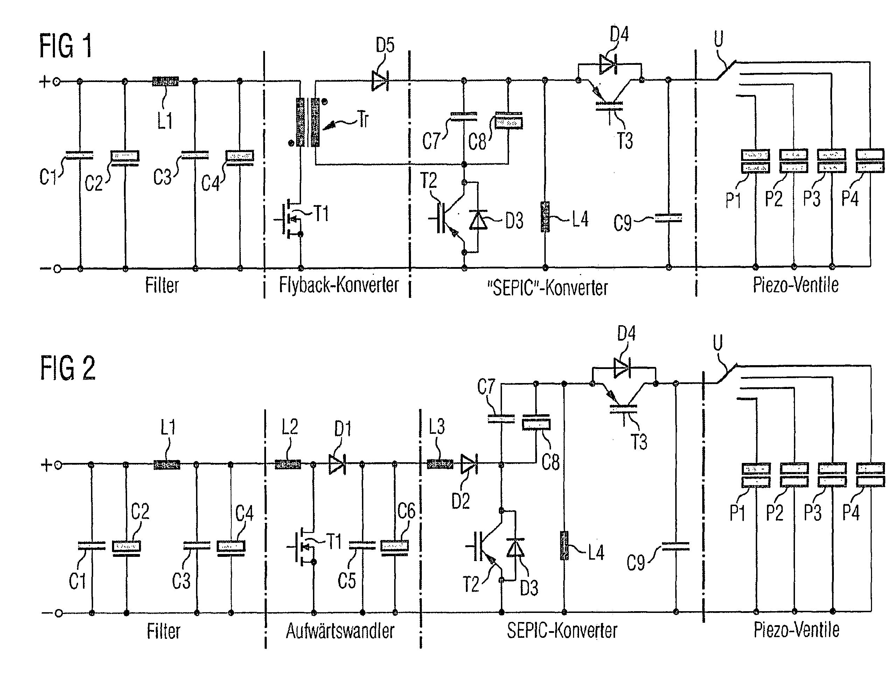

Bei einem bekannten Steuergerät zum Betreiben von Piezo-Aktoren für Kraftstoff-Einspritzventile, welches in ähnlicher Ausführung beispielsweise bei dem Kraftfahrzeug-Modell A8 der Marke Audi verwendet wird, siehe Figur 2, wird die Bordnetzspannung (12V) über ein Filter (L1 und C1 bis C4) und eine Reihenschaltung zweier Aufwärtswandler bzw. eines Auf- und eines Auf-/Abwärts-Wandlers in eine hohe Spannung (von bis zu 300V) zur Ansteuerung der Piezo-Aktoren umgewandelt. Die Bordnetzspannung wird einem DC/DC-Aufwärtswandler (L2, T1, D1 und C5, C6) zugeführt, welcher an einem massebezogenen Zwischenkreiskondensator C5, C6 eine hohe Spannung (von bis zu 300V) aufbaut. Auf diese Weise wird die hohe Dynamik abgepuffert und die Spannung angehoben.

Der dafür notwendige DC/DC-Aufwärtswandler stellt eine in sich geschlossene Einheit dar. An den Zwischenkreiskondensator C5, C6 wird eine Endstufe angeschlossen, welche als Auf- oder Auf-/Abwärts-Wandler (Boost- oder Buck-Boost-Konverter), beispielsweise als SEPIC-Konverter (Single-Ended Primary Inductance Converter, bestehend aus L3, L4, D2 bis D4, T2, T3 und C7 bis C9) in abgewandelter Form ausgebildet ist, die letztlich die Piezo-Aktoren P1 bis P4, in Figur 2 beispielsweise für vier Kraftstoff-Einspritzventile, über einen Umschalter U ansteuert.

Die SEPIC-Endstufe, die als Eingangsspannung etwa 80V benötigt, da sie selbst auch die Spannung weiter hochsetzen kann, bildet wiederum einen unabhängigen Wandler. Im Steuergerät werden also 2 voneinander unabhängig agierende Wandler hintereinander eingebaut. Jede Einheit wird für sich optimiert, woraus sich ein bestimmter Wirkungsgrad, Platzbedarf und Preis ergibt.

Bei der Endstufe ist die SEPIC-Topologie zwar übernommen, aber die Auslegung extrem untypisch gewählt, da der Koppelkondensator C7, C8 im wesentlichen energiespeichernde Funktion hat und die Eingangsdrossel L3 nur geringe Energiemengen nachladen muss.

Es ist Aufgabe der Erfindung, ein Steuergerät für Piezo-Aktoren von Kraftstoff-Einspritzventilen mit verbessertem Wirkungsgrad, geringerem Platzbedarf und geringeren Kosten zu schaffen.

Diese Aufgabe wird erfindungsgemäß durch ein Steuergerät für Piezo-Kraftstoff-Einspritzventile gemäß den Merkmalen von Anspruch 1 gelöst.

Vorteilhafte Weiterbildungen der Erfindung sind den Unteransprüchen zu entnehmen. Ein Ausführungsbeispiel nach der Erfindung wird nachstehend anhand einer schematischen Zeichnung näher erläutert. In der Zeichnung zeigen:
- Figur 1: ein erfindungsgemäßes Steuergerät für Piezo-Aktoren von Kraftstoff-Einspritzventilen, und
- Figur 2: ein an sich bekanntes Steuergerät.

Figur 2 zeigt das bereits weiter oben beschriebene, bekannte Ausführungsbeispiel eines Steuergeräts für Piezo-Aktoren von Kraftstoff-Einspritzventilen.

Ein Filter, bestehend aus einer ersten Drossel L1 und Kondensatoren C1 bis C4, ist erforderlich, um wegen der hohen Ansteuerfrequenz des Aufwärtswandlers Störungen auf das 12V-Bordnetz zu verhindern. Die parallelgeschalteten Kondensatoren C1 und C2 liegen zwischen Pluspol (+) und Minuspol (-) der Bordnetzspannung, beispielsweise 12V. Ebenfalls zwischen Pluspol und Minuspol liegt eine Reihenschaltung aus erster Drossel L1 und zwei parallelgeschalteten Kondensatoren C3 und C4. Der Verbindungspunkt von Drossel L1 und Kondensatoren C3, C4 ist der Filteranschluss, zugleich Eingang eines Aufwärtswandlers.

Der Aufwärtswandler besteht aus einer zwischen Filterausgang und Minuspol liegenden Reihenschaltung einer zweiten Drossel L2 und eines ersten Transistors T1 sowie einer zwischen Verbindungspunkt von zweiter Drossel L2 und erstem Transistor T1 und dem Minuspol liegenden Reihenschaltung einer ersten Diode D1 und eines Zwischenkreis-Kondensators, bestehend aus zwei parallelgeschalteten Kondensatoren C5 und C6, wobei die erste Diode D1 in Richtung von der zweiten Drossel L2 zum Zwischenkreis-Kondensator C5, C6 stromleitend ist.

Transistor T1 des Aufwärtswandlers arbeitet als Schalter, der mittels einer von der am Zwischenkreis-Kondensator C6 anliegenden Ausgangsspannung pulsweiten-modulierten Steuerspannung ein- und ausgeschaltet wird und auf diese Weise eine hohe, möglichst konstante Ausgangsspannung gewünschter Amplitude am Zwischenkreis-Kondensator C5, C6 bewirkt.

Während der Einschaltphase des ersten Transistors T1 fällt die Eingangsspannung (Bordnetzspannung) im wesentlichen an der zweiten Drossel L2 ab und der durch sie fließende Strom steigt an. Schaltet der Transistor T1 ab, so fließt der Strom über die erste Diode D1 weiter und lädt den Zwischenkreis-Kondensator C5, C6.

Mit dieser am Zwischenkreis-Kondensator C5, C6 anliegenden Spannung wird jeweils einer der Piezo-Aktoren P1 bis P4 der Einspritzventile mittels des auf den Aufwärtswandler folgenden SEPIC-Konverters - welcher die am Zwischenkreis-Kondensator C5, C6 anliegende Spannung ggf. weiter hochsetzt - pulsweise angesteuert. Die zeitliche Ansteuerung der Piezo-Aktoren erfolgt schließlich mittels einer nicht dargestellten Motorsteuerung über Transistoren T2, T3 und den Umschalter U, der auch, anders als in Figur 2 dargestellt, zwischen den Piezo-Aktoren und dem Minuspol der Bordnetzspannung liegen kann.

Die generelle Arbeitsweise eines SEPIC-Konverters ist beispielsweise in "Intersil Application Note No. AN9208, April 1994, S. 11-181 beschrieben.

Der SEPIC-Konverter, der in abgewandelter Form in diesem vorbekannten Beispiel die Endstufe bildet, ist folgendermaßen aufgebaut:

Zwischen dem Ausgang des Aufwärtswandlers - dem Verbindungspunkt zwischen erster Diode D1 und dem Zwischenkreis-Kondensator C5, C6 - und dem Minuspol ist eine Reihenschaltung, bestehend aus einer dritten Drossel L3, einer zweiten Diode D2 und einem zweiten Transistor T2 angeordnet, wobei die zweite Diode D2 in Richtung von der dritten Drossel D3 zum zweiten Transistor T2 hin stromleitend ist.

Zwischen dem Verbindungspunkt von zweiter Diode D2 und zweitem Transistor T2 und dem Minuspol ist eine weitere Reihenschaltung aus einem Koppelkondensator, bestehend aus zwei parallelgeschalteten Kondensatoren C7 und C8, und einer vierten Drossel L4 angeordnet.

Zwischen dem Verbindungspunkt des Koppelkondensators C7, C8 und der vierten Drossel L4 und dem Minuspol liegt eine Reihenschaltung eines dritten Transistors T3 und eines Kondensators C9, wobei der Umschalter U den Verbindungspunkt zwischen drittem Transistor T3 und dem Kondensator C9 mit den Piezo-Aktoren P1 bis P4 der Kraftstoff-Einspritzventile verbindet.

Die beiden Transistoren T2 und T3 sind beispielsweise als IGBT ausgebildet, wobei jeweils eine (dritte und vierte) Diode D3, D4 zwischen Emitter und Kollektor des Transistors angeordnet ist, die vom Emitter zum Kollektor stromleitend ist.

Das Laden und Entladen der Piezo-Kraftstoff-Einspritzventile P1 bis P4 erfolgt folgendermaßen:

Zu Beginn des Ladevorgangs sind die Drosseln L3 und L4 stromlos. Der zu ladende Piezo-Aktor P1 bis P4 wird mit dem Umschalter U selektiert. Der zweite Transistor T2 wird leitend geschaltet, der Verbindungspunkt zwischen Drossel L4, Koppelkondensator C7,C8 und drittem Transistor T3 bekommt negatives Potential. In der Drossel L4 baut sich ein Strom auf.

Sobald dieser Strom einen gewünschten Wert erreicht, wird der zweite Transistor T2 nichtleitend gesteuert und der Strom läuft über die vierte Diode D4 und Kondensator C9 frei, wobei die in der Drossel L4 gespeicherte Energie auf den Kondensator C9 und den selektierten Piezo-Aktor übertragen wird. Sobald der Strom durch die Drossel L4 auf null gesunken ist, beginnt der nächste Puls. Diese Pulse wiederholen sich so lange, bis der Piezo-Aktor auf einen gewünschten Wert geladen ist. Dann beginnt der nächste Arbeitstakt.

Durch die Drossel L3 baut sich während des Ladevorganges ein kleiner Strom auf, der jedoch auf den prinzipiellen Ablauf keinen Einfluss hat. Er kann zur Steigerung der Genauigkeit von dem Messsignal des Stromes in der vierten Drossel L4 abgezogen werden. Der Strom durch die Drossel L3 lädt den Koppelkondensator C7, C8 wieder auf den Wert des Zwischenkreises C5,C6 auf, wobei es zu einer Spannungsüberhöhung kommt. Die Spannungsüberhöhung ist von vielen Faktoren abhängig und beeinflusst die erreichbare Genauigkeit.

Zu Beginn des Entladevorganges ist Kondensator C9 geladen und Drossel L4 ist stromlos. Transistor T3 wird leitend gesteuert, um beim Entladen des Piezo-Aktors in der Drossel L4 einen Strom aufzubauen. Hat dieser Strom einen gewünschten Wert erreicht, wird Transistor T3 nichtleitend gesteuert, der Strom läuft über den Koppelkondensator C7,C8 und die dritte Diode D3 frei. Die Energie wird auf den Koppelkondensator C7,C8 übertragen. Sobald dieser Strom auf null gesunken ist, beginnt der nächste Puls. Diese Pulse wiederholen sich so lange, bis der Piezo-Aktor entladen ist. Dann beginnt der nächste Arbeitstakt.

Neben dem beschriebenen Betrieb an der Lückgrenze (nächster Arbeitstakt startet bei Erreichen von Strom null) kann die Endstufe auch lückend und nichtlückend arbeiten.

In Figur 1 ist ein erfindungsgemäßes Steuergerät für Piezo-Aktoren von Kraftstoff-Einspritzventilen dargestellt.

Zwischen Pluspol (+) und Minuspol (-) der Bordnetzspannung liegt, wie in Figur 2, ein Filter, bestehend aus den Kondensatoren C1 bis C4 und der ersten Drossel L1, an deren Anschluss wieder ein, diesmal aber als Sperrwandler ausgebildeter DC/DC-Aufwärtswandler angeordnet ist.

Dieser Aufwärtswandler besteht aus einem Übertrager Tr, dessen Primärwicklung in Reihe mit einem Schalttransistor T1 zwischen dem Filteranschluss und dem Minuspol angeordnet ist. Auf den Aufwärtswandler folgt wieder, wie bei dem bekannten Beispiel nach Figur 2, der als SEPIC-Konverter ausgebildete Aufwärtswandler, bei welchem jedoch die dritte Drossel L3 und eine Diode, beispielsweise die zweite Diode D2, nicht mehr vorhanden sind.

Der eine Anschluss der galvanisch getrennten Sekundärwicklung des Übertragers Tr ist direkt mit dem Verbindungspunkt des Koppelkondensators C7, C8 und des zweiten Transistors T2 verbunden, während der andere Anschluss über eine fünfte Diode D5 mit dem anderen Anschluss des Koppelkondensators C7, C8 verbunden ist, wobei die fünfte Diode D5 in Richtung von der Sekundärwicklung zu diesem anderen Anschluss des Koppelkondensators C7, C8 stromleitend ist. Die Diode D5 kann jedoch auch in der Verbindungsleitung zwischen dem Verbindungspunkt des Koppelkondensators C7, C8 und des zweiten Transistors T2 und der Sekundärwicklung des Übertragers Tr liegen.

Die restliche Schaltung des SEPIC-Konverters (L4, C9), des Umschalters U und der Piezo-Aktoren P1 bis P4 der Kraftstoff-Einspritzventile entspricht derjenigen nach Figur 2.

Das Laden und Entladen der Piezo-Aktoren P1 bis P4 der Kraftstoff-Einspritzventile mittels des erfindungsgemäßen Steuergeräts erfolgt im wesentlichen in gleicher Weise, pulsweise, wie weiter oben bei der bekannten Ausführung nach Figur 2 beschrieben.

Wesentlicher Unterschied und vorteil der erfindungsgemäßen Lösung ist jedoch, dass hier der Nachladestrom für den Koppelkondensator C7,C8 nicht die Strommessung in L4 negativ beeinflusst. Eine Spannungsüberhöhung tritt nur bei sehr langer Pause zwischen Lade- und Entlade-Vorgang auf.

Die erfindungsgemäße Schaltung nach Figur 1 hat gegenüber der bekannten Schaltung nach Figur 2 folgende Vorteile:
- der Koppelkondensator C7, C8 übernimmt nun die Funktion des Zwischenkreiskondensators C5, C6, welcher dadurch, zusammen mit der zweiten Diode D2 und der dritten Drossel L3, überflüssig wird und entfallen kann;
- durch den Entfall der Bauelemente C5, C6, D2 und L3 wird Platz gewonnen (ca. 2cm²);
- durch den Entfall der Bauelemente C5, C6 und D2 werden Kosten gespart;
- durch den Ersatz der beiden Drosseln L2 und L3 durch den Übertrager Tr verringern sich die Kosten auf etwa 60% der Kosten für die beiden Drosseln L2, L3;
- die Verluste des Gesamtsystems sinken, da die erheblichen Verluste (ca. 2W) in Drossel L2, L3 und Diode D2 entfallen, während die Verluste des Flyback-Konverters nur unwesentlich höher sind als die des Boost-Konverters. Dadurch ergibt sich insgesamt ein besserer Wirkungsgrad;
- die Versorgung der Treiber für die Halbleiterschalter kann wesentlich vereinfacht werden, da der als Flyback-Konverter ausgebildete Aufwärtswandler (über weitere Sekundärwicklungen) mehrere Ausgangsspannungen mitregeln kann, während bei der bekannten Variante des Aufwärtswandlers weitere Bauteile für eigene DC/DC-Spannungswandler für die Treiberversorgung anfallen;
- der Nachladestrom für den Koppelkondensator C7,C8 beeinflusst die Strommessung in der Drossel L4 nicht negativ, so dass die Genauigkeit zunimmt;
- eine Spannungsüberhöhung beim Wiederaufladen des Koppelkondensators C7, C8 kann nur bei sehr langer Pause zwischen Lade- und Entlade-Vorgang auftreten (was bei dem vorgesehenen Verwendungszweck praktisch nie vorkommt, so dass die Genauigkeit zunimmt.

## Patentansprüche

1. Steuergerät für Piezo-Aktoren (P1 bis P4) von Kraftstoff-Einspritzventilen, mit einer Reihenschaltung eines DC/DC-Aufwärtswandlers und einer als SEPIC-Konverter ausgebildeten Endstufe - welche eingangsseitig eine Reihenschaltung eines zweiten Transistors (T2), dessen Emitter mit dem Minuspol (-) einer Bordspannung verbunden ist, und eines Koppelkondensators (C7, C8) aufweist - von welcher die Piezo-Aktoren (P1 bis P4) mittels eines Umschalters (U) angesteuert werden,
**dadurch gekennzeichnet,**
- **dass** der DC/DC-Aufwärtswandler als Flyback-Konverter mit einem Übertrager (Tr) ausgebildet ist,
- **dass** der eine Anschluss der Sekundärwicklung des Übertragers (Tr) mit dem Verbindungspunkt von zweitem Transistor (T2) und Koppelkondensator (C7, C8) des SEPIC-Konverters verbunden ist, und
- **dass** der andere Anschluss der Sekundärwicklung des Übertragers (Tr) mit dem anderen Anschluss des Koppelkondensators (C7, C8) des SEPIC-Konverters über eine fünfte Diode (D5) verbunden ist, welche in Richtung von der Sekundärwicklung des Übertragers (Tr) zu diesem anderen Anschluss des Koppelkondensators (C7, C8) stromleitend ist.

2. Steuergerät nach Anspruch 1, **dadurch gekennzeichnet, dass** die fünfte Diode (D5) in der Verbindungsleitung zwischen der Sekundärwicklung des Übertragers (Tr) und dem Verbindungspunkt von zweitem Transistor (T2) und Koppelkondensator (C7, C8) liegt.

3. Steuergerät nach Anspruch 1, **gekennzeichnet durch** seine Verwendung in einer Kraftfahrzeug-Brennkraftmaschine.

## Claims

1. Control device for piezo actuators (P1 to P4) of fuel injection valves, with a series circuit comprising a DC/DC up converter and an output stage taking the form of a SEPIC converter - which on the input side has a series circuit comprising a second transistor (T2) whose emitter is connected to the negative pole (-) of an onboard electrical system voltage, and a coupling capacitor (C7, C8) - by which the piezo actuators (P1 to P4) are controlled by means of a changeover switch (U),
**characterised in that**
- the DC/DC up converter takes the form of a flyback converter with a transformer (Tr),
- the one connection of the secondary winding of the transformer (Tr) is connected to the connecting point of the second transistor (T2) and the coupling capacitor (C7, C8) of the SEPIC converter, and
- the other connection of the secondary winding of the transformer (Tr) is connected to the other connection of the coupling capacitor (C7, C8) of the SEPIC converter by way of a fifth diode (D5) which is conducting in the direction of the secondary winding of the transformer (Tr) to this other connection of the coupling capacitor (C7, C8).

2. Control device according to claim 1, **characterized in that** the fifth diode (D5) is situated in the connecting line between the secondary winding of the transformer (Tr) and the connecting point of the second transistor (T2) and the coupling capacitor (C7, C8).

3. Control device according to claim 1, **characterized by** its use in an internal combustion engine in a motor vehicle.

## Revendications

1. Dispositif de commande pour des actionneurs piézo-électriques (P1 à P4) d'injecteurs de carburant, comprenant un montage en série d'un convertisseur amont de courant continu CC/CC et d'un étage de sortie réalisé sous la forme d'un convertisseur SEPIC - qui présente, côté entrée, un montage en série d'un deuxième transistor (T2), dont l'émetteur est relié au pôle moins (-) d'une tension de bord, et d'un condensateur de couplage (C7, C8) - qui permet de piloter les actionneurs piézo-électriques (P1 à P4) au moyen d'un inverseur (U),
**caractérisé en ce que**
- le convertisseur amont CC/CC est réalisé sous la forme d'un convertisseur de retour FLYBACK muni d'un transducteur (Tr),
- un des raccords de l'enroulement secondaire du transducteur (Tr) est relié au point de connexion du deuxième transistor (T2) et du condensateur de couplage (C7, C8) du convertisseur SEPIC, et
- l'autre raccord de l'enroulement secondaire du transducteur (Tr) est relié à l'autre raccord du condensateur de couplage (C7, C8) du convertisseur SEPIC via une cinquième diode (D5) conductrice du courant dans la direction de l'enroulement secondaire du transducteur (Tr) vers cet autre raccord du condensateur de couplage (C7, C8).

2. Dispositif de commande selon la revendication 1,
**caractérisé en ce que** la cinquième diode (D5) se trouve dans la ligne de connexion entre l'enroulement secondaire du transducteur (Tr) et le point de connexion du deuxième transistor (T2) et du condensateur de couplage (C7, C8).

3. Dispositif de commande selon la revendication 1,
**caractérisé par**
son utilisation dans un moteur à combustion interne d'un véhicule automobile.
